# EUROPEAN PATENT SPECIFICATION

(11) **EP 3 246 109 B1**
(45) Date of publication and mention of the grant of the patent: **16.08.2023**
(21) Application number: 17172029.5
(22) Date of filing: 19.05.2017
(51) Int. Cl.: B22C 9/10, B22C 9/12, B22C 9/04, B22C 9/22

(54) **CASTING SYSTEM FOR INVESTMENT CASTING PROCESS**
GUSSSYSTEM FÜR EIN PRÄZISIONSGUSSVERFAHREN
SYSTÈME DE MOULAGE POUR UN PROCÉDÉ DE DE FONTE DE PRÉCISION

(30) Priority: 19.05.2016 US 201615159296
(43) Date of publication of application: 22.11.2017
(73) Proprietor: Raytheon Technologies Corporation, Farmington, CT 06032 (US)
(72) Inventor: SLAVENS, Thomas N., Moodus, CT 06469 (US); CASTLE, Lea Kennard, Vernon, CT 06066 (US); AUXIER, James Tisley, Bloomfield, CT 06002 (US)
(74) Representative: Dehns

(56) References cited:
- EP-A1- 1 914 030
- US-A1- 2016 101 462
- DATABASE WPI Week 199320 Thomson Scientific, London, GB; AN 1993-165841 XP002774621, & SU 1 736 671 A1 (CHELY POLY) 30 May 1992 (1992-05-30)
- SACHS E ET AL: "CAD-CASTING: DIRECT FABRICATION OF CERAMIC SHELLS AND CORES BY THREE DIMENSIONAL PRINTING", MANUFACTURING REVIEW, AMERICAN SOCIETY OF MECHANICAL ENGINEERS, NEW YORK, US, vol. 5, no. 2, 1 June 1992 (1992-06-01), pages 117-126, XP000270075, ISSN: 0896-1611

## Description

### BACKGROUND OF THE INVENTION

The present disclosure relates to investment casting, and more particularly to a casting system for use in investment casting processes.

Many gas turbine engine components are made using an investment casting process. Investment casting is a commonly used technique for forming metallic components having complex geometries, such as the components of a gas turbine engine. The investment casting process used to create a gas turbine engine component is as follows. A mold is prepared having one or more mold cavities, each having a shape generally corresponding to the component to be cast. A wax pattern of the component is formed by molding wax over a core.

In a shelling process, a shell is formed around one or more such patterns. The wax is removed by melting in an autoclave, for example. The shell is fired to harden the shell such that a mold is formed comprising the shell having one or more part defining compartments that include the core. Molten alloy is then introduced to the mold to cast the component. Upon cooling and solidifying of the alloy, the shell and core are destructively removed, such as by mechanical abrasion, water blasting, and/or leaching, for example.

US 2016/0101462 A1 discloses a prior art investment casting system in accordance with the preamble of claim 1, and a prior art method in accordance with the preamble of claim 9.

SACHS E ET AL: "CAD-CASTING: DIRECT FABRICATION OF CERAMIC SHELLS AND CORES BY THREE DIMENSIONAL PRINTING", MANUFACTURING REVIEW, AMERICAN SOCIETY OF MECHANICAL ENGINEERS, NEW YORK, US, vol. 5, no. 2, 1 June 1992, pages 117-126, discloses an investment casting system for a turbine airfoil, comprising a 3D printed core which is post-processed by dipping it into a slurry consisting of colloidal silica binder and submicron alumina powder, in order to improve its surface smoothness and strength.

### SUMMARY OF THE DISCLOSURE

According to an aspect of the present invention, there is provided an investment casting system as set forth in claim 1.

In an exemplary embodiment of the above described investment casting system the strengthening coating is applied to an entirety of the core.

In an alternative exemplary embodiment of the above described investment casting system the strengthening coating is only applied to the at least one fine detail, (and thus not applied to the entirety of the core).

In another exemplary embodiment of any of the above described investment casting systems the strengthening coating is applied to at least a portion of the shell.

In another exemplary embodiment of any of the above described investment casting systems the strengthening coating is a non-reactive material.

In another exemplary embodiment of any of the above described investment casting systems the at least one fine detail includes a negative space of at least one film cooling hole.

In another exemplary embodiment of any of the above described investment casting systems the core is an investment casting core of at least one of an airfoil, a blade outer air seal (BOAS), and a combustor liner.

In another exemplary embodiment of any of the above described investment casting systems the strengthening coating is at least one of a metal oxide, a nitride, a carbide and a silicide coating.

In another exemplary embodiment of any of the above described investment casting systems the strengthening coating is one of a vapor deposition coating and a spray coating.

According to a further aspect of the present invention, there is provided a method as set forth in claim 9.

In an example of the above described exemplary method of providing a casting system for an investment casting process coating at least a fine detail of a core comprises coating an entire exterior surface of the core with the strengthening coating.

In a further example of any of the above described exemplary methods of providing a casting system for an investment casting process the step of coating at least the fine detail of the core for use in a strengthening coating is preformed using a vapor deposition process.

In a further example of any of the above described exemplary methods of providing a casting system for an investment casting process the vapor deposition process applies a coating to at least a portion of a shell simultaneous with application of the coating to the at least one fine detail of the core.

A further example of any of the above described exemplary methods of providing a casting system for an investment casting process further includes a step of finishing a cast component by removing at least one artifact of a vapor deposition port in the shell.

In a further example of any of the above described exemplary methods of providing a casting system for an investment casting process the step of coating at least the fine detail of the core for use in a strengthening coating is preformed using a spray coating process.

In a further example of any of the above described exemplary methods of providing a casting system for an investment casting process coating at least the fine detail of the core includes the coating at least partially infiltrating the core material.

### BRIEF DESCRIPTION OF THE DRAWINGS

Figure 1 is a schematic view of an example gas turbine engine.
Figure 2 illustrates a portion of an example casting system for an investment casting process.
Figure 3 illustrates a strengthening coating of the casting system of Figure 2.
Figure 4 illustrates a strengthening coating applied to an alternative example core for the casting system of Figure 2.
Figure 5 illustrates a strengthening coating applied to another alternative example core for the casting system of Figure 2.
Figure 6 illustrates a strengthening coating applied to another alternative example core for the casting system of Figure 2.
Figure 7 illustrates an example method for providing a casting system for an investment casting process.

### DETAILED DESCRIPTION OF THE DISCLOSED EMBODIMENT

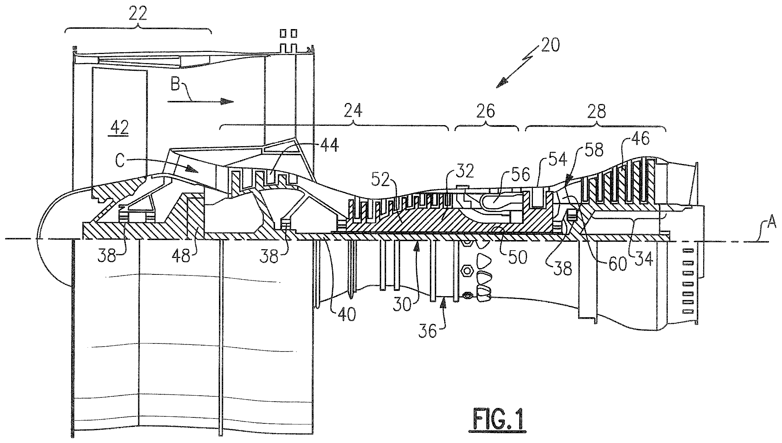

Figure 1 schematically illustrates a gas turbine engine 20. The gas turbine engine 20 is disclosed herein as a two-spool turbofan that generally incorporates a fan section 22, a compressor section 24, a combustor section 26 and a turbine section 28. Alternative engines might include an augmentor section (not shown) among other systems or features. The fan section 22 drives air along a bypass flow path B in a bypass duct defined within a nacelle 15, while the compressor section 24 drives air along a core flow path C for compression and communication into the combustor section 26 then expansion through the turbine section 28. Although depicted as a two-spool turbofan gas turbine engine in the disclosed non-limiting embodiment, it should be understood that the concepts described herein are not limited to use with two-spool turbofans as the teachings may be applied to other types of turbine engines including three-spool architectures.

The exemplary engine 20 generally includes a low speed spool 30 and a high speed spool 32 mounted for rotation about an engine central longitudinal axis A relative to an engine static structure 36 via several bearing systems 38. It should be understood that various bearing systems 38 at various locations may alternatively or additionally be provided, and the location of bearing systems 38 may be varied as appropriate to the application.

The low speed spool 30 generally includes an inner shaft 40 that interconnects a fan 42, a first (or low) pressure compressor 44 and a first (or low) pressure turbine 46. The inner shaft 40 is connected to the fan 42 through a speed change mechanism, which in exemplary gas turbine engine 20 is illustrated as a geared architecture 48 to drive the fan 42 at a lower speed than the low speed spool 30. The high speed spool 32 includes an outer shaft 50 that interconnects a second (or high) pressure compressor 52 and a second (or high) pressure turbine 54. A combustor 56 is arranged in exemplary gas turbine 20 between the high pressure compressor 52 and the high pressure turbine 54. A mid-turbine frame 57 of the engine static structure 36 is arranged generally between the high pressure turbine 54 and the low pressure turbine 46. The mid-turbine frame 57 further supports bearing systems 38 in the turbine section 28. The inner shaft 40 and the outer shaft 50 are concentric and rotate via bearing systems 38 about the engine central longitudinal axis A which is collinear with their longitudinal axes.

The core airflow is compressed by the low pressure compressor 44 then the high pressure compressor 52, mixed and burned with fuel in the combustor 56, then expanded over the high pressure turbine 54 and low pressure turbine 46. The mid-turbine frame 57 includes airfoils 59 which are in the core airflow path C. The turbines 46, 54 rotationally drive the respective low speed spool 30 and high speed spool 32 in response to the expansion. It will be appreciated that each of the positions of the fan section 22, compressor section 24, combustor section 26, turbine section 28, and fan drive gear system 48 may be varied. For example, gear system 48 may be located aft of combustor section 26 or even aft of turbine section 28, and fan section 22 may be positioned forward or aft of the location of gear system 48.

The engine 20 in one example is a high-bypass geared aircraft engine. In a further example, the engine 20 bypass ratio is greater than about six, with an example embodiment being greater than about ten, the geared architecture 48 is an epicyclic gear train, such as a planetary gear system or other gear system, with a gear reduction ratio of greater than about 2.3 and the low pressure turbine 46 has a pressure ratio that is greater than about five. In one disclosed embodiment, the engine 20 bypass ratio is greater than about ten, the fan diameter is significantly larger than that of the low pressure compressor 44, and the low pressure turbine 46 has a pressure ratio that is greater than about five. Low pressure turbine 46 pressure ratio is pressure measured prior to inlet of low pressure turbine 46 as related to the pressure at the outlet of the low pressure turbine 46 prior to an exhaust nozzle. The geared architecture 48 may be an epicycle gear train, such as a planetary gear system or other gear system, with a gear reduction ratio of greater than about 2.3:1. It should be understood, however, that the above parameters are only exemplary of one embodiment of a geared architecture engine and that the present invention is applicable to other gas turbine engines including direct drive turbofans.

A significant amount of thrust is provided by the bypass flow B due to the high bypass ratio. The fan section 22 of the engine 20 is designed for a particular flight condition -- typically cruise at about 0.8 Mach and about 35,000 feet (10,668 meters). The flight condition of 0.8 Mach and 35,000 ft (10,668 m), with the engine at its best fuel consumption - also known as "bucket cruise Thrust Specific Fuel Consumption ('TSFC')" - is the industry standard parameter of lbm of fuel being burned divided by lbf of thrust the engine produces at that minimum point. "Low fan pressure ratio" is the pressure ratio across the fan blade alone, without a Fan Exit Guide Vane ("FEGV") system. The low fan pressure ratio as disclosed herein according to one non-limiting embodiment is less than about 1.45. "Low corrected fan tip speed" is the actual fan tip speed in ft/sec divided by an industry standard temperature correction of [(Tram °R) / (518.7 °R)]^0.5 (where °R = K x 9/5). The "Low corrected fan tip speed" as disclosed herein according to one non-limiting embodiment is less than about 1150 ft / second (350.5 m/s).

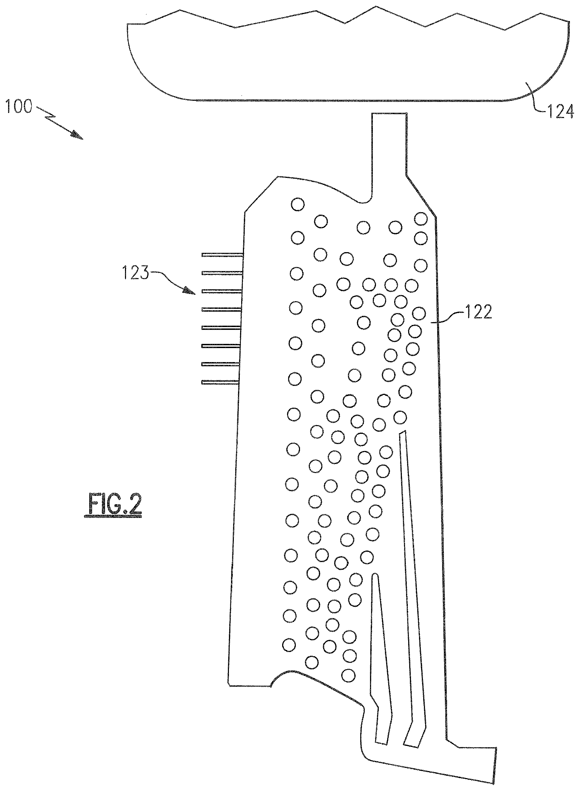

Figure 2 illustrates a portion of an example casting system 100 for creating a part for the gas turbine engine 20 in an investment casting process. It should be understood that the casting system 100 may be utilized to create any type of part, including but not limited to, airfoils, blade outer air seal (BOAS), combustor liners, or any other internally-cored and investment-cast components. The casting system 100 includes a core 122 and a shell 124.

The shell 124 is positioned relative to the core 122. The core 122 and the shell 124 are spaced relative to one another in a known manner. In one example, some portions of the core 122 and the shell 124 contact one another. The core 122 is utilized to create the internal features of a gas turbine engine part, such as cooling channels, film cooling holes, and the like. The shell 124 is utilized to form the external features of the corresponding part. In one example, the core 122 and the shell 124 are made of ceramic materials. However, the core 122 and the shell 124 may include any composition.

In an example investment casting process, a casting alloy is introduced into the casting system 100 to cast the part. In one example, the casting alloy is poured into the casting system 100. Upon cooling and solidifying of the casting alloy, the part is removed from the core 122 and the shell 124, such as by mechanical abrasion, water blasting, and/or leaching, for example.

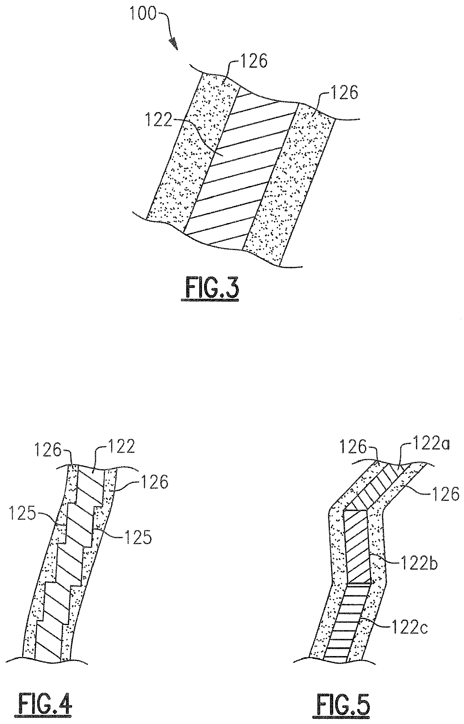

Figure 3 illustrates a strengthening coating 126 of the casting system 100. In one example, the strengthening coating 126 is applied to the core 122. In another example, the strengthening coating 126 is applied to the shell 124 of the casting system 100. In another example, the strengthening coating 126 is applied to both the core 122 and the shell 124 of the casting system 100. In some examples, the coating 126 at least partially infiltrates, and merges with, the core material.

In the illustrated example, the strengthening coating 126 is applied to an outer surface of each of the core 122 and the shell 124. In alternative examples, only a portion of the casting system 100 is coated with the strengthening coating 26.

Some cores 122 include extremely small, or thin, components that create fine features in the resultant part. These features are referred to as fine details, and are susceptible to breakage prior to or during a casting process absent the strengthening coating 126. One such feature is a negative image of a film cooling hole, which takes the form of a thin pin-like protrusion 123 from the core 122. Another such feature would be a thin wall of a hollow core 122.

It should be understood that the strengthening coating 126 may be applied to a casting system having any composition, including but not limited to, ceramic and metallic crucible compositions. Moreover, a person of ordinary skill in the art having the benefit of this disclosure would understand that the strengthening coating 126 could be applied to any portion of the casting system 100 that comes into contact with the casting alloy during the investment casting process.

With continued reference to Figures 2 and 3, Figure 4 illustrates a portion of an example casting system 100, where the core 122 is constructed using an additive manufacturing technique. As a result of the additive manufacturing process, one or more exterior surfaces 125 of the core 122 exhibit a substantial surface roughness. In certain aircraft applications, and similar applications, the surface roughness resultant from the additive manufacturing process may be undesirable.

In such an example, the strengthening coating 126 provides a smoothing effect, where the exterior surface of the strengthening coating 126 has a reduced surface roughness, relative to the surface roughness of the exterior surface of the core 122.

In the examples of Figures 2-4, the strengthening coating 126 is a coating that reinforces and fuses to the structure of the casting system 100. The strengthening coating 126 may include any of a plurality of coating compositions. For example, the strengthening coating 126 may include at least one of metal oxides, nitrides, carbides and silicides. In another example, the strengthening coating 126 includes any mixture of and/or layered combination of metal oxides, nitrides, carbides and silicides.

With continued reference to Figures 2-4, Figure 5 illustrates another exemplary configuration of the casting system 100. As with the examples of Figures 3 and 4, a core 122 is coated with the strengthening coating 126 along the exterior surface of the core 122. In the example of Figure 5, the core 122 is constructed of at least 3 distinct components 122a, 122b, 122c. Each of the core components 122a, 122b, 122c abuts at least one of the other core components 122a, 122b, 122c to form a complete core structure. Once positioned correctly, relative to each other, the strengthening coating is applied to core components 122a, 122b, 122c. The strengthening coating 126 further functions to join the core components 122a, 122b, 122c, and maintain their relative positions throughout the casting process. While illustrated as planar joints in Figure 5, one of skill in the art having the benefit of this disclosure will understand that any joint type can be utilized to the same effect.

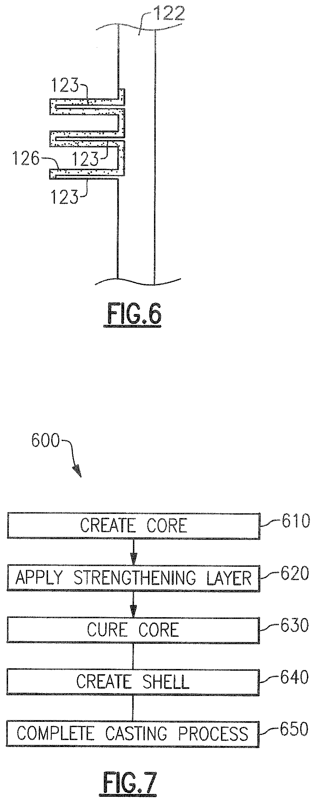

With continued reference to Figures 2-5, Figure 6 illustrates a further exemplary configuration of the casting system 100 of Figure 2. The example of Figure 6 includes multiple fine details, such as pin shaped details 123 for forming film cooling holes, included on the core 122. In the example of Figure 6, a strengthening coating 126 is applied only to the fine details, and is not applied to the entirety of the core 122. One of skill in the art will further recognize that a small portion of the strengthening coating 126 in this example can extend beyond the fine details to immediately adjacent portions of the core 122. A configuration similar to the exemplary configuration of Figure 6 can be utilized by one of skill in the art when strengthening of the entire core 122 is not necessary, but the fine details are required to be strengthened.

Referring to Figures 2-5, The strengthening coating 126 is applied to the casting system 100 by any of a variety of methods including, but not limited to, chemical vapor deposition, plasma enhanced chemical vapor deposition, slurry dip coating, vacuum impregnation, pressure impregnation, electron beam physical vapor deposition, electrophoretic coating, plasma spray coating, electrostatic powder coating, conversion coating, liquid pressure liquid spray coating and any combination of methods thereof. In another example, multiple layer strengthening coatings 126 are applied within either a single process method or a combination of methods, and could be utilized to create a function graded coating system. A coating methodology of this type deals with coating stresses that originate due to differences in the coefficient of thermal expansion between the core 122 and/or shell 124 and a surface barrier layer of the part. A person of ordinary skill in the art having the benefit of this disclosure would be able to apply the example barrier coating 26 using any of the above mentioned methods.

Figure 7 illustrates an example method 600 for providing a casting system 100 for an investment casting process. Initially the base core is created in a "create core" step 610. The base core can be created using any known method of manufacturing the base core, including ceramic core construction, additive manufacturing, milling, casting, etc. Once the base core is created, the strengthening coating is applied to the base core in an "Apply Strengthening Coating" step 620. The strengthening coating can be applied to the base core in any of the above described methods, and can be applied either to the entirety of the core, or to only a portion of the core depending on the needs of the specific casting system 100. After applying the strengthening coating, the core is cured in a "Cure Core" step 630. By way of example, the core can be cured using a firing process. Alternatively, any other known curing process could be utilized in place of firing the core. Once the core is cured, wax is injected around the core creating a positive solid of the intended cast component and a shell is created around the wax solid in a "Create Shell" step 640. Alternatively, any other similar material can be used in place of wax. Once the shell is created, the casting process is completed in any conventional manner in a "Complete Casting Process" step 640.

One of skill in the art, however, will recognize that the application of the strengthening coating to the base core is not limited to occurring prior to the curing of the core. By way of example, the application of the strengthening coating can occur after the core has been cured, and before the shell is created.

In an alternate example, the strengthening coating is applied after the shell has been created. In such an example, the strengthening coating is applied via a vapor deposition, or similar, process, and is provided to interior portions of the core via ports in the shell. Any artifacts of the ports in the cast component can be removed via milling, abrasion, or any other known finishing process.

Further, one of skill in the art, having the benefit of this disclosure will recognize that the application of the strengthening coating can occur at numerous potential points within the process, and the particular manner in which the strengthening coating is applied can be determined based on the needs of the specific casting process.

The foregoing description shall be interpreted as illustrative and not in any limiting sense. A worker of ordinary skill in the art would understand that certain modifications would come within the scope of this disclosure. For these reasons, the following claims should be studied to determine the true scope and content of this disclosure.

## Claims

1. An investment casting system (100) comprising:
a core (122) having at least one fine detail (123);
a shell (124) positioned relative to said core (122); and
a strengthening coating (126) applied at least to said at least one fine detail (123),
**characterised in that**:
the core (122) includes at least one additively manufactured component;
an exterior surface roughness of the strengthening coating is less than a surface roughness of the core (122);
said core (122) comprises at least two distinct core components (122a, 122b, 122c); and
said strengthening coating (126) maintains a relative position of the at least two distinct core components (122a, 122b, 122c).

2. The investment casting system (100) of claim 1, wherein said strengthening coating (126) is applied to an entirety of said core (122).

3. The investment casting system (100) of claim 1 or 2, wherein said strengthening coating (126) is applied to at least a portion of said shell (124).

4. The investment casting system (100) of any preceding claim, wherein said strengthening coating (126) is a non-reactive material.

5. The investment casting system (100) of any preceding claim, wherein the at least one fine detail (123) includes a negative space of at least one film cooling hole.

6. The investment casting system (100) of any preceding claim, wherein the core (122) is an investment casting core of at least one of an airfoil, a blade outer air seal (BOAS), and a combustor liner.

7. The investment casting system (100) of any preceding claim, wherein the strengthening coating (126) is at least one of a metal oxide, a nitride, a carbide and a silicide coating.

8. The investment casting system (100) of any preceding claim, wherein the strengthening coating (126) is one of a vapor deposition coating and a spray coating.

9. A method of providing a casting system (100) for an investment casting process comprising the step of coating at least a fine detail (123) of a core (122) for use in the investment casting process using a strengthening coating (126),**characterised in that**:
coating (126) at least a fine detail (123) of the core (122) further comprises smoothing an additively manufactured surface of the core (122) using the strengthening coating (126);
the core (122) includes multiple components (122a, 122b, 122c); and
the strengthening coating (126) maintains a relative position of the multiple components (122a, 122b, 122c).

10. The method of claim 9, wherein coating at least a fine detail (123) of a core (122) comprises coating an entire exterior surface of the core (122) with the strengthening coating (126).

11. The method of claim 9 or 10, wherein the step of coating at least the fine detail (123) of the core (122) in a strengthening coating (126) is preformed using a vapor deposition process.

12. The method of claim 11, wherein the vapor deposition process applies a coating (126) to at least a portion of a shell (124) simultaneous with application of the coating (126) to the at least one fine detail (123) of the core (122).

13. The method of claim 12, further comprising a step of finishing a cast component by removing at least one artifact of a vapor deposition port in said shell (124).

14. The method of any of claims 9 to 13, wherein the step of coating at least the fine detail of the core (122) in a strengthening coating (126) is preformed using a spray coating process.

15. The method of any of claims 9 to 14, wherein coating at least the fine detail of the core includes the coating (126) at least partially infiltrating the core material.

## Patentansprüche

1. Präzisionsgusssystem (100), umfassend:
einen Kern (122), der mindestens ein feines Detail (123) aufweist;
eine Schale (124), die relativ zu dem Kern (122) positioniert ist; und
eine Verstärkungsbeschichtung (126), die zumindest auf das mindestens eine feine Detail (123) aufgebracht ist, **dadurch gekennzeichnet, dass**:
der Kern (122) mindestens eine additiv hergestellte Komponente beinhaltet;
eine Außenflächenrauhigkeit der Verstärkungsbeschichtung geringer ist als eine Oberflächenrauhigkeit des Kerns (122);
der Kern (122) mindestens zwei unterschiedliche Kernkomponenten (122a, 122b, 122c) umfasst; und
die Verstärkungsbeschichtung (126) eine relative Position der mindestens zwei unterschiedlichen Kernkomponenten (122a, 122b, 122c) aufrechterhält.

2. Präzisionsgusssystem (100) nach Anspruch 1, wobei die Verstärkungsbeschichtung (126) auf den gesamten Kern (122) aufgebracht ist.

3. Präzisionsgusssystem (100) nach Anspruch 1 oder 2, wobei die Verstärkungsbeschichtung (126) auf mindestens einen Teil der Schale (124) aufgebracht ist.

4. Präzisionsgusssystem (100) nach einem der vorhergehenden Ansprüche, wobei die Verstärkungsbeschichtung (126) ein nichtreaktives Material ist.

5. Präzisionsgusssystem (100) nach einem der vorhergehenden Ansprüche, wobei das mindestens eine feine Detail (123) einen Negativraum von mindestens einem Filmkühlloch beinhaltet.

6. Präzisionsgusssystem (100) nach einem der vorhergehenden Ansprüche, wobei der Kern (122) ein Präzisionsgusskern von mindestens einem von einem Schaufelblatt, einer äußeren Schaufelluftdichtung (BOAS) und einem Brennkammereinsatz ist.

7. Präzisionsgusssystem (100) nach einem der vorhergehenden Ansprüche, wobei die Verstärkungsbeschichtung (126) mindestens eines aus einem Metalloxid, einem Nitrid, einem Carbid und einer Silicidbeschichtung ist.

8. Präzisionsgusssystem (100) nach einem der vorhergehenden Ansprüche, wobei die Verstärkungsbeschichtung (126) eine aus einer Dampfabscheidungsbeschichtung und einer Sprühbeschichtung ist.

9. Verfahren zum Bereitstellen eines Gusssystems (100) für ein Präzisionsgussverfahren, umfassend den Schritt von Beschichten mindestens eines feinen Details (123) eines Kerns (122) zur Verwendung in dem Präzisionsgussverfahren unter Verwendung einer Verstärkungsbeschichtung (126), **dadurch gekennzeichnet, dass**:
das Beschichten (126) mindestens eines feinen Details (123) des Kerns (122) ferner Glätten einer additiv hergestellten Oberfläche des Kerns (122) unter Verwendung der Verstärkungsbeschichtung (126) umfasst;
der Kern (122) mehrere Komponenten (122a, 122b, 122c) beinhaltet; und
die Verstärkungsbeschichtung (126) eine relative Position der mehreren Komponenten (122a, 122b, 122c) aufrechterhält.

10. Verfahren nach Anspruch 9, wobei das Beschichten mindestens eines feinen Details (123) eines Kerns (122) Beschichten einer gesamten Außenfläche des Kerns (122) mit der Verstärkungsbeschichtung (126) umfasst.

11. Verfahren nach Anspruch 9 oder 10, wobei der Schritt des Beschichtens mindestens des feinen Details (123) des Kerns (122) mit einer Verstärkungsbeschichtung (126) unter Verwendung eines Dampfabscheidungsverfahrens durchgeführt wird.

12. Verfahren nach Anspruch 11, wobei das Dampfabscheidungsverfahren eine Beschichtung (126) auf mindestens einen Teil einer Schale (124) gleichzeitig mit dem Aufbringen der Beschichtung (126) auf das mindestens eine feine Detail (123) des Kerns (122) aufbringt.

13. Verfahren nach Anspruch 12, ferner umfassend einen Schritt von Endbearbeiten einer gegossenen Komponente durch Entfernen mindestens eines Artefakts einer Dampfabscheidungsöffnung in der Schale (124).

14. Verfahren nach einem der Ansprüche 9 bis 13, wobei der Schritt des Beschichtens mindestens des feinen Details des Kerns (122) mit einer Verstärkungsbeschichtung (126) unter Verwendung eines Sprühbeschichtungsverfahrens durchgeführt wird.

15. Verfahren nach einem der Ansprüche 9 bis 14, wobei das Beschichten mindestens des feinen Details des Kerns beinhaltet, dass die Beschichtung (126) mindestens teilweise das Kernmaterial infiltriert.

## Revendications

1. Système de moulage de précision (100) comprenant :
un noyau (122) ayant au moins un détail fin (123) ;
une coque (124) positionnée par rapport audit noyau (122) ; et
un revêtement de renforcement (126) appliqué au moins sur ledit au moins un détail fin (123), **caractérisé en ce que** :
le noyau (122) comporte au moins un composant fabriqué de manière additive ;
une rugosité de surface extérieure du revêtement de renforcement est inférieure à une rugosité de surface du noyau (122) ;
ledit noyau (122) comprend au moins deux composants de noyau distincts (122a, 122b, 122c) ; et
ledit revêtement de renforcement (126) maintient une position relative des au moins deux composants de noyau distincts (122a, 122b, 122c).

2. Système de moulage de précision (100) selon la revendication 1, dans lequel ledit revêtement de renforcement (126) est appliqué sur une totalité dudit noyau (122).

3. Système de moulage de précision (100) selon la revendication 1 ou 2, dans lequel ledit revêtement de renforcement (126) est appliqué sur au moins une partie de ladite coque (124).

4. Système de moulage de précision (100) selon une quelconque revendication précédente, dans lequel ledit revêtement de renforcement (126) est un matériau non réactif.

5. Système de moulage de précision (100) selon une quelconque revendication précédente, dans lequel l'au moins un détail fin (123) comporte un espace négatif d'au moins un trou de refroidissement de film.

6. Système de moulage de précision (100) selon une quelconque revendication précédente, dans lequel le noyau (122) est un noyau de moulage de précision d'au moins l'un d'un profil aérodynamique, d'un joint d'air externe d'aube (BOAS) et d'une chemise de chambre de combustion.

7. Système de moulage de précision (100) selon une quelconque revendication précédente, dans lequel le revêtement de renforcement (126) est au moins l'un d'un revêtement d'oxyde métallique, de nitrure, de carbure et de siliciure.

8. Système de moulage de précision (100) selon une quelconque revendication précédente, dans lequel le revêtement de renforcement (126) est l'un d'un revêtement par dépôt en phase vapeur et d'un revêtement par pulvérisation.

9. Procédé de fourniture d'un système de moulage (100) pour un processus de moulage de précision comprenant l'étape de revêtement d'au moins un détail fin (123) d'un noyau (122) à utiliser dans le processus de moulage de précision en utilisant un revêtement de renforcement (126), **caractérisé en ce que** :
le revêtement (126) d'au moins un détail fin (123) du noyau (122) comprend en outre le lissage d'une surface fabriquée de manière additive du noyau (122) en utilisant le revêtement de renforcement (126) ;
le noyau (122) comporte plusieurs composants (122a, 122b, 122c) ; et
le revêtement de renforcement (126) maintient une position relative des multiples composants (122a, 122b, 122c).

10. Procédé selon la revendication 9, dans lequel le revêtement d'au moins un détail fin (123) d'un noyau (122) comprend le revêtement d'une surface extérieure entière du noyau (122) avec le revêtement de renforcement (126).

11. Procédé selon la revendication 9 ou 10, dans lequel l'étape de revêtement d'au moins le détail fin (123) du noyau (122) dans un revêtement de renforcement (126) est préformée en utilisant un procédé de dépôt en phase vapeur.

12. Procédé selon la revendication 11, dans lequel le procédé de dépôt en phase vapeur applique un revêtement (126) sur au moins une partie d'une coque (124) simultanément avec l'application du revêtement (126) sur l'au moins un détail fin (123) du noyau (122).

13. Procédé selon la revendication 12, comprenant en outre une étape de finition d'un composant coulé en supprimant au moins un artefact d'un orifice de dépôt en phase vapeur dans ladite coque (124).

14. Procédé selon l'une quelconque des revendications 9 à 13, dans lequel l'étape de revêtement d'au moins le détail fin du noyau (122) dans un revêtement de renforcement (126) est préformée en utilisant un processus de revêtement par pulvérisation.

15. Procédé selon l'une quelconque des revendications 9 à 14, dans lequel le revêtement d'au moins le détail fin du noyau comporte le revêtement (126) infiltrant au moins partiellement le matériau du noyau.
